# EUROPEAN PATENT SPECIFICATION

(11) **EP 2 023 483 B1**
(45) Date of publication and mention of the grant of the patent: **02.03.2011**
(21) Application number: 07290994.8
(22) Date of filing: 09.08.2007
(51) Int. Cl.: H03F 3/60, H03F 1/52

(54) **Circulator bank for use in multiband power amplifier modules**
Zirkulatorbank zur Verwendung in Multiband-Stromverstärkungsmodulen
Banc d'accélérateur destiné à une utilisation dans des modules d'amplificateur de puissance multibande

(43) Date of publication of application: 11.02.2009
(73) Proprietor: Alcatel Lucent, 75008 Paris (FR)
(72) Inventor: Pascht, Andreas, Dr., 73635 Rudersberg (DE); Nass, Tobias, 70435 Stuttgart-Zuffenhausen (DE); Wiegner, Dirk, Dipl.-Ing., 71409 Schwaikheim (DE)
(74) Representative: Schmidt, Werner Karl

(56) References cited:
- EP-A- 1 255 353
- EP-A- 1 345 321
- KR-A- 20010 078 459

## Description

### Field of the invention

The present invention relates to a circulator bank for use in multiband power amplifier modules. In particular, the present invention relates to a multiband/multistandard power amplifier module for a base-station of a wireless communication system.

### Background and prior art

A power amplifier module is usually composed of a power amplifier and a circulator device. The circulator device is, for example, necessary to deflect a reflected signal from an antenna, which reflected signal could damage the power amplifier module. This may occur, if the antenna of a base station is dismounted during operation thereof. The power amplifier is used to amplify incoming signals over their whole frequency range.

Especially for multiband/multistandard power amplifier modules, which are e.g. used for software defined radio applications, different frequency bands and standards have to be covered by one single amplifier, making high demands regarding bandwidth, output power, efficiency, costs, etc..

Currently, e.g. the realization of a power amplifier covering a very wide bandwidth (e.g. 800 MHz - 2,7 GHz) for high output power levels is a main problem. Since the available bandwidth of a power transistor decreases with increased output power, it is very difficult or not realizable to cover the complete mentioned frequency range by a single power transistor for high output power levels and acceptable performance.

It is known to use pre- and driver amplifier stages for amplifying signals over the complete frequency range up to medium output power levels. To reach a higher output level suitable partitioning of the frequency range can be done. Thus, separate power transistors can be used for the final amplifier stage, which have to cover smaller bandwidths. Partitioning of the frequency range is usually done by frequency splitters or a non-frequency selective power divider as known from data sheet of Mini-Circuits "Coaxial Power Splitter/Combiner" (www. minicircuits.com). However, known frequency splitters show a very high power loss. Furthermore, frequency switches are known to partition the complete wide frequency range into suitable smaller frequency ranges and to use separate power transistors for said smaller frequency ranges. That is, solutions are known to amplify a signal covering a very wide bandwidth within a power amplifier module.

However, the circulator device of power amplifier modules is not capable of operating at a very wide bandwidth with the required performance and for acceptable costs (e.g. 800 MHz - 2,7 GHz) as required in the above multiband/multistandard power amplifier modules. Therefore, the circulator device constitutes a hardware problem within multiband/multistandard power amplifier modules. That is, even if the power amplifier module is capable of amplifying incoming signals covering a very wide bandwidth by one of the above described solutions, the circulator device of said module constitutes a problem with respect to said bandwidth.

It is an object of the present invention to provide a power amplifier module e.g. for FDD (Frequency Division Duplex) operation mode and a method for transmitting signals within such a power amplifier module, covering frequency bands and communication standards within a very wide frequency range for high output power levels.

In EP 1 345 321 A1 a circuit and a method are provided to determine or receive an indicator of the difference in amplitude between the output signal of a first amplifier and the output signal of a second amplifier, and to adjust the gain of at least one of the first and second amplifiers dependent upon the indicator.

### Summary of the invention

According to the present invention a frequency range selector is used to select different frequency ranges of a signal covering a very wide bandwidth and to transfer each selected frequency range to a specific output port line. Each output port line comprises a dedicated circulator device, wherein the circulator devices are provided for different frequency ranges. That is, the power amplifier module according to the present invention comprises a circulator bank, wherein each selected frequency range is passed via a corresponding circulator device within said circulator bank.

An advantage of suitably partitioning the very wide bandwidth of a received signal and providing each circulator device of a circulator bank with a specific relatively small frequency range is that a plurality of smallband circulator devices can be used. With other words, the circulator bank according to the present invention forms a broadband circulator, which has a simple construction and may cover a dedicated bandwidth. Therefore, the present invention provides a multiband/multistandard power amplifier module having a broadband circulator, which is capable of handling signals covering a very wide bandwidth.

The circulator bank of the present invention enables the usage of dedicated smallband and thus low-cost circulator devices. Therefore, the present invention provides a low-cost multiband/multistandard power amplifier module. A possible application in the field of mobile radio could e.g. be a multiband/multistandard (UMTS, GSM, EDGE, WiMAX, etc.) capable circulator module for a software defined radio frontend.

Smallband circulators typically have an attenuation of less than 0.5 dB in the direction from the input of the power amplifier module to the output thereof. In contrast, the attenuation in the inverse direction can be about 50 dB. Therefore, the circulator protects the power amplifier and other electronic components against reflections from the output. Furthermore, by using a plurality of low-loss and smallband circulator devices the power amplifier module of the present invention is flexible and enables a multiband/multistandard operation with high output power and efficiency.

According to a preferred embodiment of the present invention the power amplifier module further comprises a second, inverse used frequency selector for directing the frequency ranges received from the plurality of output port lines and for transferring the output thereof to an output port of the power amplifier module. That is, the inverse used frequency switch directs the signals having a small bandwidth from the plurality of output port lines to a common output path. Then, a common antenna network can be used. In serial mode the corresponding signal is switched from a first output port line or another output port line to the common output path. That is, in serial mode the combiner operates as a switch.

According to a further embodiment of the present invention the frequency range selector is a frequency switch. Said frequency switch serves for driving the dedicated smallband circulator devices, wherein the frequency switch allows the selection of a dedicated smallband circulator. Preferably, a suitable frequency switch with low power loss is used in this invention. Using a suitable frequency switch, an intended frequency range at the input port can be selected and the related signal can be transferred to a specific output port via the corresponding circulator device.

For example, the suitable frequency switch comprises at least two output ports, a first output port being arranged within a first output path and a second output port being arranged within a second output path, said output ports being connected with an input port via said output paths, each output path being provided with at least one RF-block, each RF-block comprising a switching element and a quaterwave section, wherein for each RF-block a predetermined frequency band is selected and the length of said quaterwave section is matched to said selected frequency band in order to block incoming signals in said selected frequency band if the switching element of the corresponding RF-block is switched on.

Such a frequency switch allows selecting different frequency bands by using a switchable RF-block, based on a switching element and a quarterwave section, which are suitably combined. If the switching element is switched on, the quaterwave section may effect an inductive behavior of the RF-block directly at a splitting node of the input port and the at least two output ports. Thus the selected frequency bands, which depend on the length of the quaterwave sections, are blocked directly at said splitting node for the corresponding output paths. The length of the quaterwave sections are chosen in a manner that it corresponds to the frequency bands to be blocked.

Different RF-blocks are preferably matched to different frequency bands. By such frequency switch principle, different frequency bands which are provided with the incoming signal at the input port can be selected and transferred to different output ports, each connected to one of the plurality of output port lines comprising the circulator devices.

Preferably, during use of said switching element at least one RF-block is switched off. For improved operation, it is recommended to switch off all RF blocks which are located within the same output path. The frequency switch is then operated in serial use. In this case power loss can be minimized down to 1 dB and better for each output port.

Thus, by using a suitable frequency switch which is capable of selecting specific frequency ranges of a signal covering a very wide bandwidth, it is possible to provide the plurality of dedicated circulators of the circulator bank of the power amplifier module according to the present invention with the corresponding frequency range. For example, by switching the above frequency switch between different frequency ranges the circulator bank can handle the different frequency ranges in series. Therefore, by using a plurality of smallband and low-loss circulators a multiband/multistandard circulator for a power amplifier module can be realized covering a very wide bandwith.

As described above, an amplifier is arranged between the input of the module and the above frequency switch. Such amplifier amplifies an incoming signal in the total bandwidth up to a specific power level and is therefore also referred to as preamplifier. Additionally or alternatively a (further) amplifier can be arranged after the frequency switch in each of the plurality of output port lines. Advantageously, the (final) amplifiers of the different output port lines comprising the circulator devices are optimized with respect to the different selected frequency bands and show different gain, power and efficiency characteristics. Then, different frequency bands can be served in an optimized manner.

For example, for GSM and UMTS applications it may be advantageous if a first final amplifier of a first output port line is optimized with respect to frequencies from 1,8 GHz to 2,7 GHz and a further final amplifier of a further output port line is optimized with respect to frequencies from 0,8 GHz to 1,0 GHz. Yet, other applications and selected bandwidth are possible.

By combining the above-described circulator bank and frequency switch a power amplifier module is provided, which is suitable for applications with very wide bandwidths. In particular, such power amplifier module can achieve an improved output power and efficiency in comparison with known power amplifier modules, since all stages of such module suitably process the broadband signal. It should be noted that the above described frequency bands are only exemplary. In principle any frequency range can be chosen.

These and other aspects of the invention will be apparent from and elucidated with reference to the embodiments thereafter.

### Brief description of the drawings

Figure 1 shows a frequency switch for use in a power amplifier module according to the present invention supporting two output port paths; and
Figure 2 shows an embodiment of the power amplifier module according to the present invention.

### Detailed description of the drawing

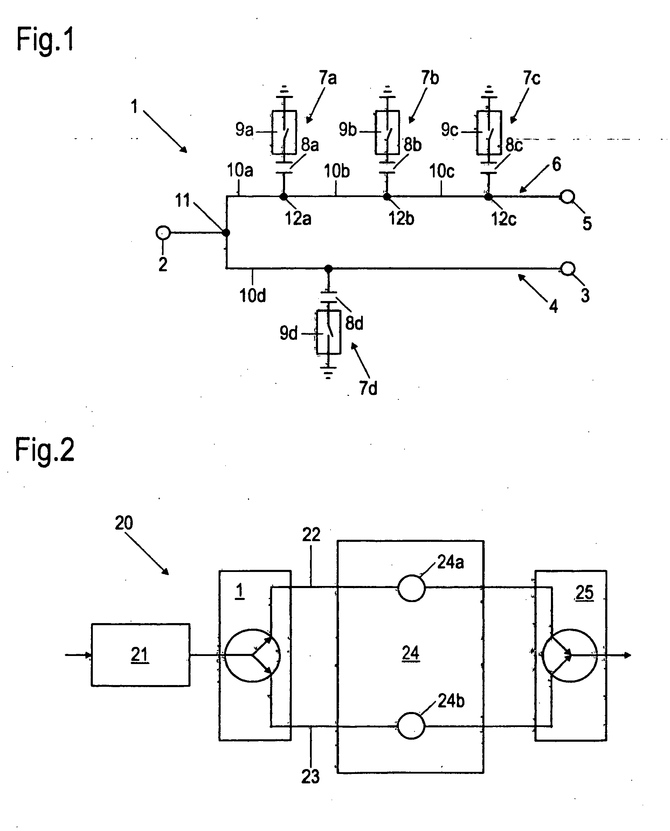

Figure 1 shows a frequency switch 1, which can be used in a power amplifier module according to the present invention having two output port paths. The frequency switch 1 comprises an input port 2, a first output port 3 arranged within a first output path 4 and a second output port 5 arranged within a second output path 6. Yet, the number of output ports can also be increased in order to achieve a finer resolution of the frequency band selection. However, in such case a suitable frequency switch configuration must be used. As mentioned above, the frequency switch configuration of Figure 1 supports only two paths. The first output path 4 is provided with one switchable RF-block 7d comprising a capacitor 8d, a quaterwave section and a switching element 9d, whereby the quaterwave section of the RF-block 7d comprises a line section 10d. The second output path 6 comprises three switchable RF-blocks 7a, 7b, 7c for an increased blocked frequency band. Each RF-block 7a, 7b, 7c comprises a capacitor 8a, 8b, 8c, a quaterwave section and a switching element 9a, 9b, 9c. The capacitors 8a-d are necessary, if certain switching elements 9a-d are used, such as diodes (used to block the DC biasing). Otherwise, the capacitors 8a-d can be omitted. The quaterwave section of the RF-block 7a comprises a line section 10a, the quaterwave section of the RF-block 7b comprises line sections 10a and 10b, and the quaterwave section of the RF-block 7c comprises line sections 10a and 10b and 10c. The frequency band to be blocked by RF-block 7b is defined by the length of the quaterwave section, which comprises line sections 10a and 10b and extends from a splitting node 11, at which the first output path 4 is connected with the second output path 6 to a further splitting node 12a to the next splitting node 12b of the second output path 6. By on-switching of the switching element 9d or switching elements 9a, 9b, 9c either the first output path 4 or the second output path 6 can be blocked (serial use).

In the example shown in figure 1 a first selected frequency band of the RF-block 7d comprises 800MHz - 1000MHz and a second selected frequency band of the RF-blocks 7a, 7b, 7c comprises 1800MHz - 2700MHz. The illustrated frequency switch comprises three switchable RF-blocks in the second path to achieve a better attenuation over the larger frequency band (1800MHz - 2700MHz) than is achieved with only one switchable RF-Block. In case of two smaller frequency bands in the output paths only one switchable RF-block could be used in each of the two output paths. If a signal with frequencies of 900 MHz at the input port 2 has to be transferred to the second output port 5 the switching elements 9a, 9b, 9c all have to put in off-state, while switching element 9d of the first output path 4 has to put in on-state. That means that the selected frequency band of the RF-block 7d of the first output path 4 is RF-blocked while the second output path 6 is shortened to the input port 2. A simulation of the above mentioned case (900 MHz at output port 5) shows that the power loss of the signal in the second output path 6 is approximately 0,8 dB. The first output path 4 is blocked better than -3 dB within simulated frequency band (0 GHz - 4 GHz) and better than -15 dB in the selected 900 MHz band (800 MHz - 1000 MHz).

For transferring signals with frequencies of 1800 MHz - 2700 MHz from the input port 2 to the first output port 3, switching elements 9a, 9b, 9c all have to put in on-state, while switching element 9d of the first output path 4 has to put in off-state. Simulations show that in this case the power loss of the signal in the first output path 4 is approximately 0,5 - 0,7 dB, while the second output path 6 is blocked better than -4 dB within the simulated frequency band (0 GHz - 4 GHz) and better than -8 dB in the selected 1,8 GHz - 2,7 GHz band.

Since the simulation results are based on a first design approach of the described frequency switch 1, further optimizations are to be expected in the future. The required size of the described frequency switch 1 depends on e.g. frequencies and relative permittivity εᵣ of the used substrate of the quaterwave sections 10a, 10b, 10c, 10d. Sizes of approximately 5 cm x 2 cm are achieved, but the sizes can be clearly reduced by suitable arrangement of the lines.

Figure 2 shows an embodiment of a power amplifier module 20 according to the present invention. The power amplifier module comprises an amplifier 21, which amplifies a received signal in the total bandwidth up to a specific level. Then, the amplified signal is transferred to a frequency range selector. The frequency range selector can be embodied, for example, by the frequency switch 1 shown in figure 1, if the power amplifier module 20 has two output port lines. Otherwise, another suitable frequency switch must be used. The output ports 3, 5 of the frequency switch 1 of figure 1 are connected to first and second output port lines 22, 23 of the power amplifier module of the present invention. The frequency switch 1 transfers a selected frequency range to the corresponding output port line. The selected frequency range is transferred via the corresponding output port line to a dedicated circulator device of a plurality of circulator devices 24a, 24b of a circulator bank 24. The circulator devices 24a, 24b are provided for different frequency ranges. Then, the selected frequency range is transferred via the corresponding output port line from the dedicated circulator device to an inverse used frequency switch 25. The inverse used frequency switch 25 acts as a combiner, wherein the inverse used frequency switch, for example, basically corresponds to the frequency switch 1.

As mentioned above, the frequency switch 1 of figure 1 can, for example, select a first frequency band comprising 800 MHz - 1000 MHz and a second frequency band comprising 1800 MHz - 2700 MHz. In this case, the first circulator device 24a is adapted to handle the frequency range of 800 MHz - 1000 MHz and the second circulator device 24b is adapted to handle the frequency range of 1800 MHz - 2700 MHz. Thus, the circulator bank 24 of Figure 2 is capable of handling a very wide frequency range.

### List of Reference Numerals

- 1: frequency switch
- 2: input port
- 3: first output port
- 4: first output path
- 5: second output port
- 6: second output path
- 7 a-d: switchable RF-blocks
- 8 a-d: capacitors
- 9 a-d: switching elements
- 10 a-d: line sections
- 11: splitting node
- 12 a-c: splitting nodes
- 20: power amplifier module
- 21: amplifier
- 22: first output port line
- 23: second output port line
- 24: circulator bank
- 24 a-b: circulator devices
- 25: inverse used frequency switch

## Claims

1. A power amplifier module (20) comprising:
- an input port for receiving a signal covering a very wide bandwidth,
- a frequency range selector (1) for selecting a certain frequency range of said signal, and
- a plurality of output port lines (22, 23), wherein the frequency range selector (1) transfers the selected frequency range to a specific output port line,
**characterized in that** each output port line (22, 23) comprises a dedicated circulator device and the circulator devices (24a, 24b) are provided for different frequency ranges.

2. The power amplifier module (20) of claim 1, further comprising an amplifier (21) for amplifying the received signal in the total bandwidth up to a specific level, wherein the amplifier (21) is located between the input port and the frequency range selector (1).

3. The power amplifier module (20) of claim 1, wherein each output port line (22, 23) comprises an amplifier and wherein these amplifiers are located between the frequency range selector (1) and the circulator devices (24a, 24b).

4. The power amplifier module (20) of claim 1, further comprising an inverse used frequency switch (25) for combining the frequency ranges received from the plurality of output port lines (22, 23) and transferring the output thereof to an output port of the power amplifier module (20).

5. The power amplifier module (20) of claim 1, wherein the circulator devices (24a, 24b) are dedicated smallband and low-loss circulators.

6. The power amplifier module (20) of claim 1, wherein the frequency range selector (1) is a frequency switch.

7. Method for signal transmission within a power amplifier module (20) comprising the steps of:
- receiving a signal covering a wide bandwidth, and
- selecting a certain frequency range of said signal,
**characterized by**
- transferring said selected frequency range to a specific output port line of a plurality of output port lines (22, 23), wherein each output port line comprises a dedicated circulator device and wherein the circulator devices (24a, 24b) are provided for different frequency ranges.

8. The method of claim 7, wherein the received signal is amplified in the bandwidth up to a specific level before a certain frequency range is selected.

9. The method of claim 7, wherein each selected frequency range is amplified before passing said selected frequency range to the dedicated circulator device.

10. The method of claim 7, wherein the selected frequency range is transferred from the dedicated circulator device to a inverse used frequency switch (25), which directs different frequency ranges from different circulator devices (24a, 24b) to one port.

11. A transceiver module for a base station comprising a power amplifier module (20) according to any of claims 1 to 6.

12. A base station of a mobile communication system comprising a power amplifier module (20) according to any of claims 1 to 6.

## Patentansprüche

1. Leistungsverstärker-Modul (20), umfassend:
- Einen Eingangsport zum Empfangen eines eine sehr große Bandbreite abdeckenden Signals,
- einen Frequenzbereich-Selektor (1) zum Auswählen eines bestimmten Frequenzbereichs des besagten Signals, und
- eine Mehrzahl von Ausgangsportleitungen (22, 23), wobei der Frequenzbereich-Selektor (1) den ausgewählten Frequenzbereich an eine spezifische Ausgangsportleitung übermittelt,
**dadurch gekennzeichnet, dass** jede Ausgangsportleitung (22, 23) eine dedizierte Zirkulatorvorrichtung umfasst und die Zirkulatorvorrichtungen (24a, 24b) für verschiedene Frequenzbereiche bereitgestellt werden.

2. Der Leistungsverstärker-Modul (20) nach Anspruch 1, weiterhin umfassend einen Verstärker (21) zum Verstärken des empfangenen Signals in der Gesamtbandbreite bis zu einem bestimmten Pegel, wobei der Verstärker (21) zwischen dem Eingangsport und dem Frequenzbereich-Selektor (1) angeordnet ist.

3. Der Leistungsverstärker-Modul (20) nach Anspruch 1, wobei jede Ausgangsportleitung (22, 23) einen Verstärker umfasst, und wobei diese Verstärker zwischen dem Frequenzbereich-Selektor (1) und den Zirkulatorvorrichtungen (24a, 24b) angeordnet sind.

4. Der Leistungsverstärker-Modul (20) nach Anspruch 1, weiterhin umfassend einen invers benutzten Frequenzschalter (25) zum Kombinieren der von der Mehrzahl von Ausgangsportleitungen (22, 23) empfangenen Frequenzbereiche und zum Übermitteln des Ausgangs davon an einen Ausgangsport des Leistungsverstärker-Moduls (20).

5. Der Leistungsverstärker-Modul (20) nach Anspruch 1, wobei die Zirkulatorvorrichtungen (24a, 24b) dedizierte verlustarme Schmalband-Zirkulatoren sind.

6. Der Leistungsverstärker-Modul (20) nach Anspruch 1, wobei der Frequenzbereich-Selektor (1) ein Frequenzschalter ist.

7. Verfahren zur Übertragung von Signalen innerhalb eines Leistungsverstärker-Moduls (20), wobei das Verfahren die folgenden Schritte umfasst:
- Empfangen eines Signals, welches eine große Bandbreite abdeckt, und
- Auswählen eines bestimmten Frequenzbereichs des besagten Signals,
**gekennzeichnet durch**
- Übermitteln des besagten ausgewählten Frequenzbereichs an eine spezifische Ausgangsportleitung einer Mehrzahl von Ausgangsportleitungen (22, 23), wobei jede Ausgangsportleitung eine dedizierte Zirkulatorvorrichtung umfasst, und wobei die Zirkulatorvorrichtungen (24a, 24b) für verschiedene Frequenzbereiche bereitgestellt werden.

8. Das Verfahren nach Anspruch 7, wobei das empfangene Signal in der Bandbreit bis zu einem bestimmten Pegel verstärkt wird, bevor ein bestimmter Frequenzbereich ausgewählt wird.

9. Das Verfahren nach Anspruch 7, wobei jeder ausgewählte Frequenzbereich verstärkt wird, bevor der ausgewählte Frequenzbereich an die dedizierte Zirkulatorvorrichtung weitergeleitet wird.

10. Das Verfahren nach Anspruch 7, wobei der ausgewählte Frequenzbereich von der dedizierten Zirkulatorvorrichtung an einen invers benutzten Frequenzschalter (25) übermittelt wird, welcher verschiedene Frequenzbereiche von verschiedenen Zirkulatorvorrichtungen (24a, 24b) an einen Port weiterleitet.

11. Sender-Empfänger-Modul für eine Basisstation mit einem Leistungsverstärker-Modul (20) gemäß einem beliebigen der Ansprüche 1 bis 6.

12. Basisstation eines mobilen Kommunikationssystems mit einem Leistungsverstärker-Modul (20) gemäß einem beliebigen der Ansprüche 1 bis 6.

## Revendications

1. Module amplificateur de puissance (20), comprenant :
- un port d'entrée pour recevoir un signal couvrant une largeur de bande très large,
- un sélecteur de plage de fréquences (1) pour sélectionner une plage de fréquences donnée dudit signal, et
- une pluralité de lignes de port de sortie (22, 23), le sélecteur de plage de fréquences (1) transférant la plage de fréquences sélectionnée à une ligne de port de sortie spécifique,
**caractérisé en ce que** chaque ligne de port de sortie (22, 23) comprend un dispositif circulateur dédié et les dispositifs circulateurs (24a, 24b) sont prévus pour différentes plages de fréquences.

2. Module amplificateur de puissance (20) selon la revendication 1, comprenant en outre un amplificateur (21) pour amplifier le signal reçu dans la largeur de bande totale jusqu'à un niveau spécifique, l'amplificateur (21) se trouvant entre le port d'entrée et le sélecteur de plage de fréquences (1).

3. Module amplificateur de puissance (20) selon la revendication 1, chaque ligne de port de sortie (22, 23) comprenant un amplificateur et ces amplificateurs se trouvant entre le sélecteur de plage de fréquences (1) et les dispositifs circulateurs (24a, 24b).

4. Module amplificateur de puissance (20) selon la revendication 1, comprenant en outre un commutateur de fréquence (25) utilisé en inverse pour combiner les plages de fréquences reçues de la pluralité de lignes de port de sortie (22, 23) et pour transférer leur sortie vers un port de sortie du module amplificateur de puissance (20).

5. Module amplificateur de puissance (20) selon la revendication 1, les dispositifs circulateurs (24a, 24b) étant des circulateurs dédiés à bande étroite et à faibles pertes.

6. Module amplificateur de puissance (20) selon la revendication 1, le sélecteur de plage de fréquences (1) étant un commutateur de fréquence.

7. Procédé de transmission de signal à l'intérieur d'un module amplificateur de puissance (20) comprenant les étapes suivantes :
- réception d'un signal couvrant une largeur de bande large, et
- sélection d'une plage de fréquences donnée dudit signal,
**caractérisé par**
- le transfert de ladite plage de fréquences sélectionnée à une ligne de port de sortie spécifique d'une pluralité de lignes de port de sortie (22, 23), chaque ligne de port de sortie comprenant un dispositif circulateur dédié et les dispositifs circulateurs (24a, 24b) étant prévus pour différentes plages de fréquences.

8. Procédé selon la revendication 7, selon lequel le signal reçu est amplifié dans la largeur de bande jusqu'à un niveau spécifique avant la sélection d'une certaine plage de fréquences.

9. Procédé selon la revendication 7, selon lequel chaque plage de fréquences sélectionnée est amplifiée avant de transférer ladite plage de fréquence sélectionnée au dispositif circulateur dédié.

10. Procédé selon la revendication 7, selon lequel ladite plage de fréquence sélectionnée est transférée du dispositif circulateur dédié à un commutateur de fréquence (25) utilisé en inverse qui dirige les différentes plages de fréquences provenant de différents dispositifs circulateurs (24a, 24b) vers un port.

11. Module émetteur/récepteur pour une station de base comprenant un module amplificateur de puissance (20) selon l'une quelconque des revendications 1 à 6.

12. Station de base d'un système de communication mobile comprenant un module amplificateur de puissance (20) selon l'une quelconque des revendications 1 à 6.
